# EUROPEAN PATENT APPLICATION

(11) **EP 1 785 739 A1**
(43) Date of publication of application: **16.05.2007**
(21) Application number: 05024807.9
(22) Date of filing: 14.11.2005
(51) Int. Cl.: G01R 33/28

(54) **An elongate, segmented, RF safe device for use with an MRI machine**

(71) Applicant: DKFZ Deutsches Krebsforschungszentrum, 69120 Heidelberg (DE)
(72) Inventor: Umathum, Reiner, 69115 Heidelberg (DE); Müller, Sven, 99198 Ulbrich (DE)
(74) Representative: Hörschler, Wolfram Johannes

(57) **Abstract**

The invention relates to an elongate electrically conductive member for use with an MRI machine and to a method for reducing RF heating of such an elongate electrically conductive member within an MRI machine. The elongate electrically conductive member (2) comprises mutually separated segments (3), the separation between the segments (3) being realized by way of switchable separating elements (4), which are switchable between a high impedance and a low impedance mode.

## Description

The present invention relates to an elongate electrically conductive member for use with an MRI machine and a method for reducing RF heating of such a member within an MRI machine.

Modern interventional and surgical procedures aim to treat the affected tissue while causing minimal injury to healthy tissue structures. Special instruments are delivered to the target region via a minimal surgical opening and the affected tissue is treated.

The target of the minimally invasive operation is often not directly visible for the interventionist, thus the operations are done under imaging guidance. X-ray fluoroscopy, computed tomography, ultrasound and optical endoscopy are currently the most frequently used imaging methods. However, magnetic resonance imaging (MRI) is a state of the art imaging modality for medical diagnostics and it has potential to become a superior guidance method. Knowing the accurate position of the instrument tip inside the patient is essential, since the surgeon should be able to accurately guide the instrument to the target.

Within an MR-imaging apparatus, interventional device tracking has so far been done either by evaluating the change (gain or destruction) of the MR-signal at the position of the interventional device or by attaching an electrical conductor or a high-frequency antenna to the device.

The change of MR-signal caused by the device itself can only be used to measure the position of the device, if the device is positioned within the imaging frame. Furthermore, if the contrast between the device and its surroundings is too low, it cannot be detected. Visualisation of an interventional device could depend upon its being coated with an MR contrast agent, or upon its effect on the MR image by nature of its chemical make-up.

However, compounds and materials considered MR-compatible, and even MR contrast agents, can produce significant distortion artifacts that obscure the anatomy and physiology of the imaged tissue. Initial attempts to visualise endovascular devices in MR imaging were based on passive susceptibility artifacts produced by the device when exposed to the MR field. US 5,154,179 and US 4,989,608 disclose the incorporation of paramagnetic material into endovascular devices to make the devices visible under MR imaging.

If the device is connected to an electrical conductor with one or more windings and if these windings are passed by a direct current, a local distortion of the magnetic field of the MR-imaging apparatus is caused. This distortion causes a local alteration of the MR image. By taking two MR images, one with and one without a direct current flowing through the conductor, the position of the interventional device can be determined by the difference of the signals in the two MR images. This method is described in US 5,868,674. Within the magnetic radio frequency field of the MR-imaging apparatus, electric coupling of the wires, which are used as a current supply for the electrical conductor can lead to severe heating under certain circumstances. If the heat is not dissipated, it might result in the destruction of the device and it could be hazardous to the patient.

Another possibility for measuring the position of the interventional device is the application of a high-frequency antenna, which is attached to the device. This antenna is tuned to the resonance frequency of the MR-imaging apparatus. Therefore, the antenna is not compatible to all MR imagers. Furthermore, dangerous RF-heating can take place and the MR technique has to be adapted to this kind of device tracking.

Exemplary of methods for active MR visualisation of implanted medical devices is US 5,211,165, which discloses an MR tracking system for a catheter based on transmit/receive microcoils positioned near the end of the catheter by which the position of the device can be tracked and localised. US 5,375,596 discloses a method for locating catheters and other tubular medical devices implanted in the human body using an integrated system of wire transmitters and receivers. US 4,572,198 also provides for conductive elements, such as electrode wires, for systematically disturbing the magnetic field in a defined portion of a catheter to yield increased MR visibility of that region of the catheter. However, the presence of conductive elements in the catheter also introduces increased electronic noise and the possibility of Ohmic heating, and these factors have the overall effect of degrading the quality of the MR image and raising concerns about the patient's safety. US 5,882,305 therefore replaces long lead wires, which can cause heating during MR imaging and may distort an MR image, by at least one optical fibre. Consequently, electrical signals have to be converted into modulated optical signals and vice versa by two transducer circuits.

New concepts have been proposed to reduce RF heating of conductive wires and the like during the RF transmission of an MRI machine.

EP 1 437 601 A1 relates to a method for measuring the position and orientation of an interventional device within a magnetic resonance imaging apparatus using a Faraday sensor. The Faraday sensor is connected to an optical measuring device via optical fibres, which show no interaction with the electromagnetic fields of the MRI machine. Therefore, the problem of RF heating does not exist. On the other hand this method requires a complex assembly comprising a sophisticated electronic circuit in order to convert the high frequency magnetic resonance signal into an optical signal.

It has been discovered that long conductive wires always heat the surrounding medium (e.g. tissue) more than short wires within the RF field of an MRI machine (e.g. C.J. Yeung et al.: "RF heating due to conductive wires during MRI depends on the phase distribution of the transmit field", Magnetic Resonance in Medicine 48, 1026-1098 (2002)). Therefore, a segmentation of elongate electrically conductive members has been proposed in order to reduce RF heating.

For example a coaxial cable could be divided into segments by RF chokes, which suppress longitudinal currents on the external conductive sheath of the coaxial cable. RF chokes can be designed as broad band radio-frequency chokes or as narrow band parallel resonance circuits. Both designs are not suitable for miniaturization and can therefore not be used for cables within narrow medical devices like catheters.

S. Weiss et al.: "Transmission line for improved RF safety of interventional devices", Magnetic Resonance in Medicine 45, 182-189 (2005) describe an improvement of the RF safety of transmission lines in interventional instruments by segmenting the transmission line in short sections by employing transformers. One drawback of this method is that the magnetic resonance signal is injected directly into the separating transformers, which may lead to a false detection of the position of the catheter tip. A sufficient common mode rejection is only achieved within a very narrow frequency range and this design results in a high signal attenuation. Furthermore, the miniaturization requires great technical efforts.

The devices described in US 2004/0254450 A1 and in US 2002/0095084 A1 show the same disadvantages.

US 2004/0254450 A1 refers to a medical device for use with an MRI machine, the MRI machine adapted to apply a radio frequency pulse having a wave length which creates an image, the medical device comprising:
a first conductive elongate member;
a second conductive elongate member; and
a joint having low electrical conductivity relative to the elongate members, wherein the joint is situated between and joins the two elongate members;
wherein the length of each of the two elongate members is less than one half the wave length of the radio frequency pulse applied by the MRI machine.

US 2002/0095084 A1 is directed towards an invasive device that is intended to be introduced into an object that is to be imaged by means of an MRI apparatus. The invasive device has a distal end and is provided with an envelope that is connected thereto, with a circuit that is arranged at the area of the distal end and also with an electrical connection conductor that is connected to the circuit and extends through the envelope. The connection conductor comprises mutually separated segments, each of which is shorter than a predetermined value, and the separation between the segments is realized by way of frequency-dependent separating elements, that constitute a conductor for LF currents and an isolator for RF alternating current.

Accordingly, it is an object of the present invention to overcome the current problems of RF heating in the vicinity of elongate electrically conductive members within the RF field of an MRI machine. It is a further object of the present invention to suppress the unwanted interaction of such an elongate electrically conductive member with the radio frequency field during the excitation phase of the MRI machine, during which an RF field is generated, and to ensure the transmission of a signal by the elongate electrically conductive member with only a small signal attenuation during a reception phase of the MRI machine, during which no RF field is generated by the MRI machine.

In accordance with the object of the present invention there is provided an elongate electrically conductive member for use with an MRI machine, the elongate electrically member comprising mutually separated segments, the separation between the segments being realized by way of switchable separating elements, which are switchable between a An elongate electrically conductive member in this context is an electrically conductive member with a length greater than ¼ of the wave length of the RF waves of an MRI machine within a medium surrounding the electrically conductive member. It is for example a transmission wire, a coaxial cable, an RF antenna with or without loops or coils, any electrically conductive leads running along the length of an interventional device like medical catheters (e.g. guide catheters, diagnostic catheters, rapid exchange balloon catheters, stent delivery catheters, over-the-wire catheters etc.) and the like.

The elongate electrically conductive member of the present invention is provided for the use with an MRI machine. A conventional MRI machine includes a first magnet system for generating a homogeneous, static magnetic field, a plurality of gradient coils for generating further magnetic fields that have a gradient in the x, the y and the z direction and an RF transmitter coil to generate RF fields. An MRI signal can be received by a receiving coil, which can be a separate coil or the same coil as the transmitter coil.

The elongate electrically conductive member of the present invention is separated into at least two segments. This separation is realized by way of at least one switchable separating element. The separating element can be actively switched between a high impedance and a low impedance mode.

In the high impedance mode the separating elements are working as isolators and the separate segments of the elongate electrically conductive members are essentially electrically isolated from one another. Within the RF field of an MRI machine only small potential differences are induced between the two ends of each segment. Therefore, RF heating is kept low and does not endanger surrounding tissue. A high impedance mode in the context of this invention is a mode wherein the separating elements have an impedance which is high in relation to the resistance of the medium (e.g. saline solution or tissue of a human body) surrounding the electrically conductive member in the MRI machine. Preferably a high impedance is higher than 10kΩ.

In the low impedance mode of the separating elements, the separating elements are working as conductors and the segments of the elongate electrically conductive member form a continuous electrical conductor with a low signal attenuation. A low impedance mode in the context of this invention is a mode wherein the separating elements have an impedance which is low in relation to the resistance of the segments of the electrically conductive member. Preferably a low impedance is lower than 1Ω. The separating elements are switched to this low impedance mode, when the RF field of the MRI machine is switched off and RF heating will not take place. Then the elongate electrically conductive member can serve its purpose, e.g. to transmit induced electromagnetic signals from a sensor at the tip of the catheter or to supply a sensor at the tip of the catheter with electrical energy to permit the tracking of the catheter tip with the MRI machine.

With the elongate electrically conductive member according to the present invention it is possible to segment a transmission line actively for a selected period of time into a plurality of isolated short segments and to reconnect these segments to a continuous transmission line after this period of time has passed. The danger of local RF heating is eliminated by switching the separating elements differently during the excitation phase and the reception phase of the MRI machine. The separating element can be commercially available elements. The MRI machine does not have to be modified. The separating elements can be constructed in a very small size in order to fit into a variety of medical instruments, especially into intravascular catheters. The elongate electrically conductive member according to the present invention has the further advantage of being suitable for a wide frequency range, therefore being applicable within any MRI machine, nearly independent of its radio frequency.

According to a preferred embodiment of the present invention, the switchable separating elements which separate the segments of the elongate electrically conductive member are PIN diodes. A PIN diode is a semiconductor device that operates as a variable resistor at RF frequencies. It is a current controlled resistance. Basically it is a semiconductor diode, in which a high resistivity intrinsic I-region is sandwiched between a P- and an N-type region. When no bias is applied, the diode behaves like a small capacitance, when a bias is applied, the diode behaves like a resistor. The PIN diodes can be switched to the low impedance mode by applying a direct-current e.g. of 10mA. Without this direct-current, they are switched to their high impedance mode. An additional inverse voltage of e.g. -30V can be applied to raise the impedance in the high impedance mode.

In a preferred embodiment of the present invention, the length of each segment of the elongate electrically conductive member is less than ¼ of the wave length of the radio frequency waves caused by the MRI machine. The wave length of the radio frequency waves caused by the MRI machine are their wave lengths within the medium in the surrounding of the elongate electrically conductive member, e.g. in the surrounding tissue. This choice of the length of the segments smaller than λ/4 suffices to realize the desired effect of reducing RF heating in accordance with the invention. In a customary MRI machine the homogeneous magnetic field has a strength of 1.5 Tesla. The frequency of the RF field then amounts to 64 MHz, the wave length then being approximately 4.7 m. This RF field generates RF waves within normal human body tissue with a wave length of about 0.5 m. Therefore, the segments of the elongate electrically conductive member for use in this MRI machine are preferably shorter than 0.125 m, most preferably shorter than 0.1 m.

The segments of the elongate electrically conductive member according to the present invention can have different lengths, but preferably all have essentially the same length.

In one embodiment of the present invention the segments of the elongate electrically conductive member are segments of a coaxial cable with a conducting centre wire and a surrounding conducting sheath and the centre wires and the conducting sheaths of neighbouring segments are each separated by switchable separating elements. A coaxial cable is an electrical cable generally comprising an inner conducting wire, surrounded by an insulating spacer, surrounded by a cylindrical conducting sheath and usually surrounded by a final insulating layer. For use with an MRI machine a sensor can be located at the distal end of the coaxial cable, which can be located in the distal end of a catheter to be inserted into the body of a patient. The sensor then connects the inner conducting wire to the outer conducting sheath of the coaxial cable. A signal can then be transmitted via the inner conducting wire in one direction and back in the other direction via the conducting sheath or vice versa. The switchable separating elements between the conducting centre wires of neighbouring segments of the coaxial cable and the switchable separating elements between conducting sheath of neighbouring segments of the coaxial cable are then connected in series.

The elongate electrically conductive member in one embodiment according to the invention comprises at least one microcoil or at least one loopless antenna. The microcoil or the loopless antenna can be used to determine the position of at least one part of the elongate electrically conductive member within an MRI machine (tracking). The elongate electrically conductive member can e.g. be integrated into an invasive device with a microcoil integrated into the tip of the invasive device. A patient is imaged by an MRI machine while the invasive device is present within the body of the patient. The RF coil of the elongate electrically conductive member is connected via the other end of the member to a processing unit for processing signals that are received during the reception phase by the RF coil, in order to make the tip of the device visible. The position of the RF coil can be determined on the basis of the nature of the magnetic resonance signals received. This position can then be superposed on an image formed by means of the MRI machine and be displayed on a monitor. Loopless MR antennas can serve the same purpose. Because of their simple linear structures these antennas are easily incorporated into catheters or other interventional devices.

The invention further relates to a medical device comprising an elongate electrically conductive member according to the present invention. These medical devices can be any medical device with elongate electrically conducting lines, which is to be used within an MRI machine. They are preferably long luminal structures. Most preferably they are selected from the group of medical catheters, body coils, sensors for generating an electrocardiogram or an electroencephalogram, and ablation devices, which are used to selectively destroy body tissue.

According to a preferred embodiment of the invention the medical device is an elongate tubular member comprising at least one lumen extending there through. The elongate electrically conductive member can e.g. be arranged within a first lumen in the elongate tubular member and a second lumen of the elongate tubular member can be used to feed e.g. a medical instrument or a medicament.

The invention also relates to a method for reducing RF heating of an elongate electrically conductive member within an MRI machine, the elongate electrically conductive member comprising mutually separated segments, the separation between the segments being realized by way of switchable separating elements, which are switchable between a high impedance and a low impedance mode, comprising the steps of
- essentially electrically isolating the segments of the elongate electrically conductive member by switching the separating elements to a high impedance mode during an excitation phase of the MRI machine, during which an RF field is generated by the MRI machine and
- switching the separating elements between the segments of the elongate electrically conductive member to a low impedance mode during a reception phase of the MRI machine, during which no RF field is generated by the MRI machine.

By switching the separating elements (e.g. PIN diodes) to a high impedance mode during the excitation phase and to a low impedance mode during the reception phase, no long conductor exists during the critical excitation phase. During this phase the elongate electrically conductive member is segmented into short conductive segments by the separating elements, so that RF heating is reduced to an uncritical level. During the reception phase all segments are "reconnected" to a long conductor, which can transmit the signal with a low attenuation.

According to a preferred embodiment of the present invention at least part of the elongate electrically conductive member is tracked by the MRI machine during the reception phase of the MRI machine. The technique of tracking has already been described above in the context of microcoils or loopless antennas.

The present invention may be best understood by reference to the following description in conjunction with the accompanying drawing in which

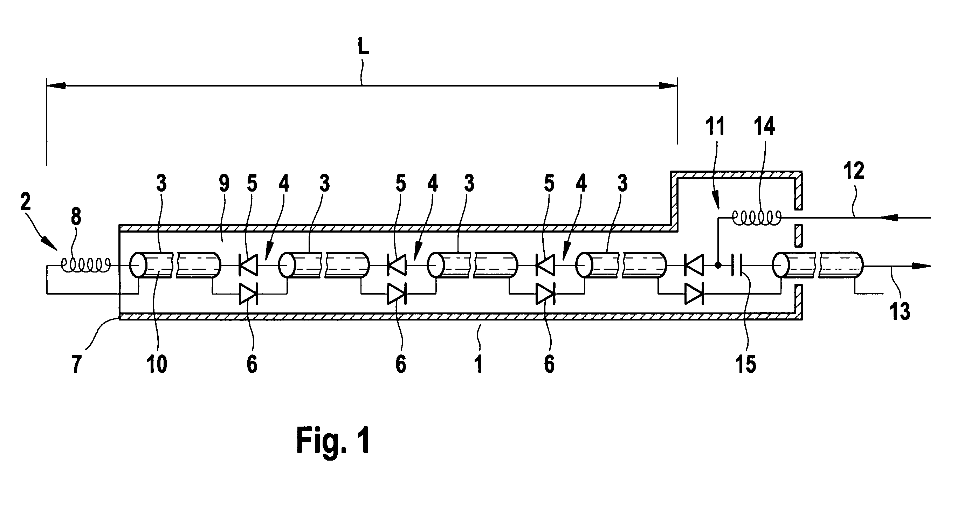

figure 1 is a schematic drawing showing a catheter with an integrated elongate electrically conductive member according to the present invention.

Figure 1 shows schematically a catheter 1 which contains an elongate electrically conductive member 2 according to the invention. The member 2 comprises four mutually separated segments 3, which are separated by switchable separating elements 4. The segments 3 are segments of a coaxial cable. Each segment 3 contains a centre wire, which is separated from the centre wire of a neighbouring segment 3 by an inner PIN diode 5. Each segment 3 also contains a conducting sheath, which is separated from the conducting sheath of a neighbouring segment by an outer PIN diode 6. At the tip 7 of the catheter 1 an RF coil 8 extends out of the lumen 9, being part of the elongate electrically conductive member 2 and being connected at one end to the conducting sheath of the fourth segment 10 and at the other end to the centre wire of the fourth segment 10. Therefore, an RF signal will pass through the centre wires of all four segments 3 and the inner PIN diodes 5, through the RF coil and back through the conducting sheath of all four segments 3 and the outer PIN diodes 6, when the PIN diodes 5, 6 are switched to the low impedance mode. The length L of the catheter which is to be used inside an MRI machine can measure e.g. 1200 mm and be divided by the separating elements 4 into four segments 3 of 300 mm length each.

The switching of the PIN diodes 5, 6 to the low impedance mode is achieved by means of the source of current 11. Therefore, a diode current 12 is fed into the elongate electrically conductive member 2. A signal current 13 received by the RF coil 8 in an MRI machine is conducted to a processing unit (not shown) in order to process the signals received by the RF coil 8. An inductance 14 separates the diode current from the signal current 13 and prevents the flowing of a signal into the source of the diode current 12. The capacitance 15 only lets the high frequency signal current 13 pass and protects the receiver of the signal current 13 from the direct-current 12. These two components 14, 15 are therefore provided to separate the direct-current 12 from the high frequency signal 13.

### Example 1

A microcoil (enamelled copper wire, ∅ = 0.22 mm, five windings with ∅ = 4 mm, length = 5 mm) was attached to the tip of a catheter. The microcoil was connected to a miniature coaxial cable (length about 1.2 m, Suhner K 01152-07, ∅ = 1,25 mm) within the lumen (∅ = 5 mm) of a polyolefine tube. The coaxial cable was connected to a processing unit of an MRI machine at its other end. In distances of 0.3 m the coaxial cable was disconnected, which means the centre wire as well as the conductive sheath were cut through. All cut-off points were then bridged by two PIN diodes (Philips BAP 51-03) at a time, which work as RF switches. All PIN diodes were connected in series for direct-current. These separating elements were switched "open" (high impedance mode) during the excitation phase within an MRI machine, during which phase strong electromagnetic fields prevail. In this way they ensured that the coaxial cable was segmented into a plurality of mutually isolated segments during this period of time. The length of the segments was small, so that the induced voltages of these segments were kept very low.

After the end of the excitation phase, the separating elements were switched "closed" (low impedance mode) by way of a direct-current of about 10 mA, so the segments were reconnected to a continuous conductor, which allowed the transmission of a signal to the processing unit of the MRI machine. The additional signal attenuation during the reception phase due to the separating elements was about 0.7 db, which equals about the signal attenuation caused by the coaxial cable itself (according to the manufacturer's instructions 0.7 db/63.685 MHz), adding up to an overall attenuation of 1.4 db. This means, that the signal voltage was attenuated along the 1.2 m long catheter by about 15 %.

With this assembly a heating measurement was carried out within an MRI machine (1.5 Tesla Siemens Magnetom Symphony). The temperature at the catheter tip was measured by means of fibre optics (Luxtron) and compared to the temperature at the tip of a similar catheter with a coaxial cable which was not segmented by separating elements. In both cases the position of measurement was chosen to be directly at the inner wall of the magnet closest to the RF excitation coil, because this is the most dangerous position for intravascular devices within an MRI machine regarding the RF heating. Both catheters were totally surrounded by a foamed material soaked with an isotonic saline solution and were arranged in parallel to the magnet bore hole. For both measurements the same sequence (TRUEFISP, TE = 1.77 ms, TR = 3.5 ms, slice thickness 12 mm, band width 814 Hz/pixel, flip angle 70°, reference voltage 253 V, total measurement time for 1340 measurements = 6 min) was used.

The measurement with the ordinary catheter with the non-segmented coaxial cable was stopped after 1.5 min, because the temperature at the tip of the catheter had risen from 30.5°C to 88°C.

The catheter according to the present invention with the segmented coaxial cable showed a temperature rise from 23.6°C to 30.8°C after the 6 min measuring time.

### Reference Numbers

- 1: catheter
- 2: elongate electrically conductive member
- 3: segments
- 4: separating elements
- 5: inner PIN diode
- 6: outer PIN diode
- 7: tip of the catheter
- 8: RF coil
- 9: lumen
- 10: fourth segment
- 11: source of current
- 12: diode current
- 13: signal current
- 14: inductance
- 15: capacitance

## Claims

1. An elongate electrically conductive member (2) for use with an MRI machine, **characterized in that** the elongate electrically conductive member (2) comprises mutually separated segments (3), the separation between the segments (3) being realized by way of switchable separating elements (4), which are switchable between a high impedance and a low impedance mode.

2. The elongate electrically conductive member (2) as claimed in claim 1, wherein the separating elements (4) are PIN diodes (5, 6).

3. The elongate electrically conductive member (2) as claimed in claim 1 or 2, wherein the length of each segment (3) is less than ¼ of the wave length of the radio frequency waves caused by the MRI machine.

4. The elongate electrically conductive member (2) as claimed in any of claims 1 to 3, wherein the segments (3) are segments of a coaxial cable with a conducting centre wire and a surrounding conducting sheath and wherein the centre wires and the conducting sheaths of neighbouring segments (3) are each separated by switchable separating elements (4).

5. The elongate electrically conductive member (2) as claimed in any of claims 1 to 4, wherein the elongate electrically conductive member (2) comprises at least one microcoil (8) or at least one loopless antenna.

6. A medical device comprising an elongate electrically conductive member (2) as claimed in any of claims 1 to 5.

7. The medical device as claimed in claim 6, wherein the medical device is at least one device selected from the group of medical catheters, body coils, sensors for generating an electrocardiogram or an electroencephalogram, and ablation devices, which are used to selectively destroy body tissue.

8. The medical device as claimed in one of claims 6 or 7, wherein the medical device is an elongate tubular member comprising at least one lumen (9) extending there through.

9. A method for reducing RF heating of an elongate electrically conductive member within an MRI machine, the electrically conductive member comprising mutually separated segments, the separation between the segments being realized by way of switchable separating elements, which are switchable between a high impedance and a low impedance mode, comprising the steps of
• essentially electrically isolating the segments of the elongate electrically conductive member by switching the elements to a high impedance mode during an excitation phase of the MRI machine, during which an RF field is generated by the MRI machine and
• switching the separating elements between the segments of the elongate electrically conductive member to a low impedance mode during a reception phase of the MRI machine, during which no RF field is generated by the MRI machine.

10. The method as claimed in claim 9, wherein at least part of the elongate electrically conductive member is tracked by the MRI machine during the reception phase of the MRI machine.
